# EUROPEAN PATENT SPECIFICATION

(11) **EP 1 949 450 B1**
(45) Date of publication and mention of the grant of the patent: **21.01.2015**
(21) Application number: 06812279.5
(22) Date of filing: 30.10.2006
(51) Int. Cl.: H01L 31/042, H01L 31/0216

(54) **SOLAR CELL OF HIGH EFFICIENCY**
SOLARZELLE MIT HOHEM WIRKUNGSGRAD
CELLULE SOLAIRE A HAUTE EFFICACITE

(30) Priority: 08.11.2005 KR 20050106220
(43) Date of publication of application: 30.07.2008
(73) Proprietor: LG Electronics Inc., Seoul 150-721 (KR)
(72) Inventor: PARK, Hyun Jung, Daejeon 305-727 (KR)
(74) Representative: Hoffmann Eitle
(86) International application number: PCT/KR2006/004439
(87) International publication number: WO 2007/055484

(56) References cited:
- JP-A- 61 222 228
- JP-A- 2005 116 740
- JP-A- 2005 311 256
- KR-A- 20050 087 248
- US-A- 4 891 325
- US-A- 6 093 882
- US-B1- 6 380 480
- YANG YIMANG FU JUNXING: "ECRCVD OF ANTIREFLECTION COATINGS FOR SI SOLAR CELLS", ACTA PHOTONICA SINICA - GUANGZI XUEBAO, SCIENCE PRESS, BEIJING, CN, vol. 26, no. 6, 1 June 1997 (1997-06-01), pages 1-5, XP007920731, ISSN: 1004-4213
- HUBNER A ET AL: "Temperature behavior of monofacial and bifacial silicon solar cells", CONFERENCE RECORD OF THE 26TH IEEE PHOTOVOLTAIC SPECIALISTS CONFERENCE - 1997. PVSC '97. ANAHEIM, CA, SEPT. 29 - OCT. 3, 1997; [IEEE PHOTOVOLTAIC SPECIALISTS CONFERENCE], NEW YORK, NY : IEEE, US, 29 September 1997 (1997-09-29), pages 223-226, XP010267767, DOI: 10.1109/PVSC.1997.654069 ISBN: 978-0-7803-3767-1
- HUBNER A ET AL: "Cost-effective bifacial silicon solar cells with 19% front and 18% rear efficiency", 19960513; 19960513 - 19960517, 13 May 1996 (1996-05-13), pages 489-492, XP010208195,
- ABERLE A G: "Overview on SiN surface passivation of crystalline silicon solar cells", SOLAR ENERGY MATERIALS AND SOLAR CELLS, ELSEVIER SCIENCE PUBLISHERS, AMSTERDAM, NL, vol. 65, no. 1-4, 1 January 2001 (2001-01-01), pages 239-248, XP004217124, ISSN: 0927-0248, DOI: 10.1016/S0927-0248(00)00099-4
- ELMIGER J R ET AL: "IN SITU PROCESS EVALUATION AND INTERFACE STUDIES ON SILICON NITRIDE FILMS FOR SILICON SOLAR CELLS", 13TH. E.C. PHOTOVOLTAIC SOLAR ENERGY CONFERENCE. NICE, FRANCE, OCT. 23 - 27, 1995; [PROCEEDINGS OF THE INTERNATIONAL PHOTOVOLTAIC SOLAR ENERGY CONFERENCE], BEDFORD : H.C. STEPHENS & ASSOCIATION, GB, vol. CONF. 13, 23 October 1995 (1995-10-23), pages 1497-1500, XP001140204, ISBN: 978-0-9521452-7-1
- MAECKEL H ET AL: "PASSIVATION QUALITY AND THERMAL STABILITY OF SILICON NITRIDE LAYERS ON SILICON AND PHOSPHORUS-DIFFUSED SILICONSOLAR CELL EMITTERS", SOLAR WORLD CONGRESS. PROCEEDINGS OF THE BIENNIAL CONGRESS OF THE INTERNATIONAL SOLAR ENERGY SOCIETY, PERGAMON PRESS, NEW YORK, NY, US, 1 January 2001 (2001-01-01), pages 1665-1674, XP008062208,

## Description

### FIELD OF THE INVENTION

The present invention relates to a high-efficiency solar cell. More specifically, the present invention relates to a solar cell which is capable of improving a photoelectric conversion efficiency by minimizing a reflectivity of absorbed light by a dual reflective film structure.composed of a passivation layer and an anti-reflective layer, in conjunction with effective prevention of carrier recombination occurring at a semiconductor surface by the passivation layer, via sequential formation of a silicon oxynitride passivation layer and a silicon nitride anti-reflective layer on a first conductivity type semiconductor substrate and a second conductivity type semiconductor layer forming a p-n junction with the first conductivity type semiconductor substrate and having a conductivity type opposite to that of the first conductivity type semiconductor substrate.

### BACKGROUND OF THE INVENTION

In recent years, with increased concerns about environmental problems and energy depletion, solar cells have drawn attention as an alternative energy source which uses abundant energy resources, is free of problems associated with environmental contamination and has a high energy efficiency.

The solar cell may be classified into a solar thermal cell which generates steam energy necessary to rotate a turbine using solar heat and a photovoltaic solar cell which converts photons into electric energy taking advantage of properties of semiconductors. In particular, a great deal of research has been actively made for photovoltaic solar cells in which electrons of p-type semiconductors and holes of n-type semiconductors, produced by absorption of light, convert into electric energy.

The important factor which is considered for the fabrication of the photovoltaic solar cells is to reduce a reflectivity of absorbed light, because the number of the created electrons and holes is determined and an amount of generated current is controlled depending upon an amount of absorbed light. Therefore, in order to decrease a light reflectivity, an anti-reflective layer is used, or a method of minimizing an incident light-shielding area upon forming electrode terminals is used. Particularly, various attempts and efforts have been actively made to develop the anti-reflective layer which is capable of achieving a high anti-reflectivity. Among various kinds of solar cells, crystalline silicon solar cells, accounting for a large portion of the solar cell market and including single-crystalline, poly- or multi-crystalline thin films, suffer from high possibility of diffusion of components of the anti-reflective layer into silicon, and therefore widely employ the dual reflective film structure having a separate passivation layer between the anti-reflective layer and a silicon layer.

For example, US Patent No. 4927770 discloses a method of reducing a reflectivity of absorbed light using an anti-reflective layer of silicon nitride and passivating a surface of silicon semiconductor layer by forming a passivation layer of silicon oxide between the silicon nitride and the silicon semiconductor layer. However, this technique has a shortcoming of process discontinuity because, upon deposition of the passivation layer and anti-reflective layer, the silicon oxide is deposited by chemical vapour deposition (CVD) while the silicon nitride is deposited by plasma enhanced chemical vapor deposition (PECVD).

Further, Korean Patent Laid-open Publication No. 2003-0079265 discloses a technique of passivating a silicon semiconductor layer with an amorphous silicon thin film, via use of a dual reflective film structure composed of the amorphous silicon thin film as a passivation layer and silicon nitride as an anti-reflective layer. However, since this technique employs the amorphous silicon thin film, it is difficult to obtain a desired degree of antireflection efficiency. In addition, according to this Korean Patent, a baking process must be carried out at a low temperature of less than 450°C, and therefore a screen printing method cannot be used in formation of electrodes, thus resulting in a need of expensive equipment such as laser equipment. That is, this method suffers from various problems such as complicated manufacturing processes and significantly increased production costs, thus making it difficult to enter practical application thereof.

Meanwhile, US Patent No. 6518200 discloses a method for fabricating composite microelectronic layers including formation of layers composed of silicon oxynitride and silicon nitride on a substrate in which a solar cell, a sensor image array, a display image array or the like is formed. However, this patent relates to a technique of using silicon oxynitride and silicon nitride as dielectric materials for current collection and is therefore, as will be described hereinafter, distinctively different from the present invention using silicon oxynitride and silicon nitride as the passivation layer and anti- reflective layer of the solar cell.

The article entitled "Cost- effective bifacial silicon solar cells with 19% front and 18% rear efficiency" by A. Hübner, A. Aberle and R. Hezel, published in Photovoltaic Specialists Conference, 1996, Conference Record of the 25th iEEE, discloses a solar cell according to the preamble of claim 1.

The article entitled "Overview on SiN surface passivation of crystalline silicon solar cells", published in Solar Energy Materials 8 Solar Cells 65 (2001) p. 239-248 relates to the properties of Si-SiN interfaces.

### SUMMARY OF THE INVENTION

Therefore, the present invention has been made to solve the above problems and other technical problems that have yet to be resolved.

The present invention provides a solar cell as set out in appended Claim 1. Optional features are set out in the dependent claims.

### BRIEF DESCRIPTION OF THE DRAWINGS

The above and other objects, features and other advantages of the present invention will be more clearly understood from the following detailed description taken in conjunction with the accompanying drawings, in which:

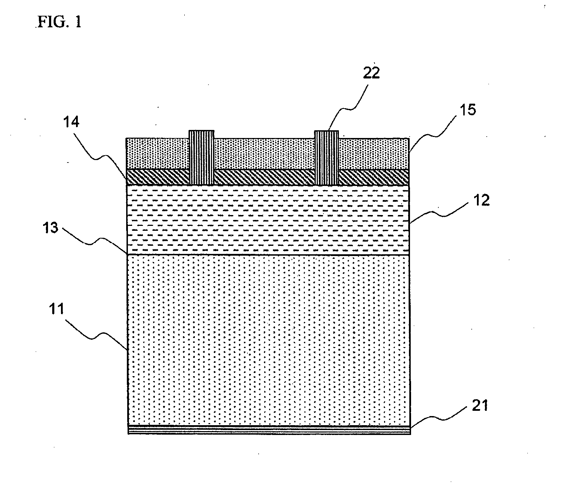

FIG. 1 is a schematic view of a solar cell composed of a semiconductor substrate, a passivation layer and an anti-reflective layer, according to a background example which is helpful for understanding the present invention.

### DETAILED DESCRIPTION OF BACKGROUND EXAMPLES AND PREFERRED EMBODIMENTS

There is described in the following a solar cell having a structure which is capable of improving a photoelectric conversion efficiency by further minimizing a reflectivity of absorbed light by a dual reflective film structure composed of a silicon oxynitride passivation layer and a silicon nitride anti-reflective layer, simultaneously with effective prevention of carrier recombination occurring at a semiconductor surface by the passivation layer.

There is also described herein a solar cell which is capable of achieving low-cost mass production capability by continuous formation of the dual reflective film structure via an in-situ process.

Furthermore, there is described a process for preparing a solar cell as described above.

The above and other advantages can be accomplished by the provision of a solar cell comprising a first conductivity type semiconductor substrate, a second conductivity type semiconductor layer formed on the first conductivity type semiconductor substrate and having a conductivity type opposite to that of the substrate, a p-n junction at an interface therebetween, a rear electrode in contact with at least a portion of the first conductivity type semiconductor substrate, a front electrode in contact with at least a portion of the second conductivity type semiconductor layer, and a silicon oxynitride passivation layer and a silicon nitride anti-reflective layer sequentially formed on a rear surface of the first conductivity type semiconductor substrate and a front surface of the second conductivity type semiconductor layer.

Therefore, the solar cell described herein has a structure including the silicon oxynitride passivation layer between the second conductivity type semiconductor layer and the silicon nitride anti-reflective layer and consequently the passivation layer in conjunction with the anti-reflective layer forms a dual reflective film structure which is thus capable of further improving a solar cell efficiency by minimizing a reflectivity of absorbed light, simultaneously with effective prevention of carrier recombination occurring at a semiconductor surface by the passivation layer.

In a preferred embodiment, the passivation layer is formed to a thickness of 40nm on the second conductivity type semiconductor layer, and the anti-reflective layer formed on the passivation layer is fabricated to have a refractive index of 1.9 to 2.3.

The first conductivity type semiconductor substrate is a p-type silicon substrate which is doped with an element of Group III of the Periodic Table such as boron (B), gallium (Ga), indium (In) or the like. The second conductivity type semiconductor layer is an n-type emitter layer which is doped with an element of Group V of the Periodic Table such as phosphorus (P), arsenic (As), antimony (Sb) or the like. The first conductivity type semiconductor substrate and the second conductivity type semiconductor layer come into contact to form a p-n junction.

FIG. 1 schematically shows a constitution of a solar cell according to a background example, which is helpful for understanding the present invention.

Referring to FIG. 1, a second conductivity type semiconductor layer 12 of a conductivity type opposite to that of a substrate is formed on a first conductivity type semiconductor substrate 11, to thereby form a p-n junction 13 at an interface therebetween. The passivation layer 14 of silicon oxynitride is formed on the second conductivity type semiconductor layer 12, and the anti-reflective layer 15 of silicon nitride is formed on the passivation layer 14.

A rear electrode 21 is formed in electrical connection with the first conductivity type semiconductor substrate 11. Whereas, a front electrode 22 is connected with the second conductivity type semiconductor layer 12 and protrudes upward from the top of the anti-reflective layer 15, through the passivation layer 14 and the anti-reflective layer 15.

The above-described solar cell may be prepared by a process comprising:
(a) forming, on a first conductivity type semiconductor substrate, a second conductivity type semiconductor layer of a conductivity type opposite to that of the substrate, thereby forming a p-n junction at an interface therebetween;
(b) forming a passivation layer of silicon oxynitride on the second conductivity type semiconductor layer;
(c) forming an anti-reflective layer of silicon nitride on the passivation layer;
(d) forming an electrode on a rear surface of the first conductivity type semiconductor substrate; and
(e) forming, on the anti-reflective layer, an electrode being connected to the second conductivity type semiconductor layer.

Hereinafter, the preparation of the background example solar cell will be specifically described step by step.

In step (a), the first conductivity type semiconductor substrate as a p-type silicon substrate doped with a Group III element such as B, Ga, In or the like, the second conductivity type semiconductor layer as an n-type emitter layer doped with a Group V element such as P, As, Sb or the like, and a p-n junction therebetween may be formed by conventional methods known in the art, such as high-temperature diffusion.

In steps (b) and (c), formation of the passivation layer on the second conductivity type semiconductor layer and formation of the anti-reflective layer on the passivation layer may be continuously carried out, for example by series of plasma enhanced chemical vapor deposition (PECVD) processes. Therefore, production costs of the solar cell can be reduced due to simplification of the corresponding manufacturing processes.

In step (d), the rear electrode may be formed, for example by screen-printing an aluminum (A1)-containing paste on the first conductivity type semiconductor substrate and baking the thus-printed paste.

Further, in step (c), when the front electrode is formed, for example by screen- printing a silver (Ag)-containing paste on the upper part of the anti-reflective layer and baking the thus-printed paste, the front electrode may be formed to be connected through the passivation layer and the anti-reflective layer to the second conductivity type semiconductor layer.

Formation of the remaining components except for the silicon oxynitride passivation layer may be carried out by conventional methods known in the art and therefore the detailed description thereof will be omitted.

Further, some of the above-mentioned manufacturing processes may be carried out in a different process sequence or otherwise may be carried out together. For example, electrode-forming processes of step (d) and step (c) may be carried out in a reverse order. If necessary, step (d) and step (c) may be carried out in conjunction with a baking process, after formation of a pattern by the corresponding paste.

In the above background example, the passivation layer and the anti-reflective layer are formed on the front surface of the second conductivity type semiconductor layer. However, in an embodiment of the present invention, the silicon oxynitride passivation layer and the silicon nitride anti-reflective layer are sequentially formed on both the rear surface of the first conductivity type semiconductor substrate and the front surface of the second conductivity type semiconductor layer.

### EXAMPLES

To further assist understanding of the present invention and how it may be put into practice, further examples of solar cell device structures and methods of fabricating the same will now be described.

### [Example 1]

A phosphorus-doped n-type emitter layer was formed on a boron-doped p-type silicon substrate to result in a p-n junction. Silicon oxynitride (SiOₓN_{y}) as a passivation layer was deposited to a thickness of 30 nm on the n-type emitter layer, by a PECVD method. Then, silicon nitride (SiNₓ) having a refractive index of 1.9 as an anti-reflective layer was deposited on the silicon oxynitride passivation layer, by a PECVD method. Next, an Al-containing paste is screen-printed on the p-type silicon substrate and an Ag-containing paste is screen-printed on the silicon nitride layer, thereby forming a pattern. The resulting structure was baked at a temperature of around 800°C for about 30 sec to simultaneously form a rear electrode connected to the p-type silicon substrate and a front electrode connected to the n-type emitter layer, thereby fabricating a solar cell.

### [Comparative Example 1]

A solar cell was fabricated in the same manner as in Example 1, except that silicon dioxide (SiO₂) was deposited on an n-type emitter layer, instead of silicon oxynitride as a passivation layer.

### [Comparative Example 2]

A solar cell was fabricated in the same manner as in Example 1, except that a silicon oxynitride passivation layer was not deposited on an n-type emitter layer.

### [Experimental Example 1]

In order to measure an efficiency of solar cells fabricated in Example 1 and Comparative Examples 1 and 2, open-circuit voltage (Voc) and short-circuit current (Jsc) were respectively measured. Then, based on the thus-measured Voc and Jsc values, a fill factor (FF) and the solar cell efficiency were measured. The results thus obtained are set forth in Table 1. Herein, the fill factor (FF) is defined as (Vmp x Jmp)/(Voc x Jsc), where Jmp and Vmp represent the current density and voltage at the maximum power point. The solar cell efficiency is given as Pmax/Pin, where Pmax represents the maximum power generated by the cell and the power input, Pin, into the system is defined to be the incident light intensity, i.e., the light energy supplied to the system per unit time.

**<Table 1>**

| Example No. | Composition of reflective film | Jsc (mA) | Voc (V) | FF (%) | Efficiency |
|---|---|---|---|---|---|
| Ex. 1 | SiOₓN_{y}/SiNₓ | 32.7 | 0.620 | 79.0 | 16.01 |
| Comp. Ex. 1 | SiO₂/SiNₓ | 32.7 | 0.616 | 78.8 | 15.87 |
| Comp. Ex. 2 | SiNₓ | 32.4 | 0.618 | 78.5 | 15.71 |

As can be seen from the results of Table 1, upon comparing with a dual reflective film structure of a silicon dioxide passivation layer (Comparative Example 1) and an anti-reflective layer composed only of a silicon nitride layer (Comparative Example 2), the solar cell of Example 1 described above exhibited a significant increase of Voc value without a decrease of Jsc value, thus confirming that the solar cell efficiency was improved by 0.14% or more. Such an improvement of the cell efficiency is a noticeable result in the art to which the present invention pertains, and is believed to be due to that the dual reflective film structure minimizes a reflectivity of absorbed light, simultaneously with effective prevention of carrier recombination occurring at a semiconductor surface by the passivation layer of silicon oxynitride.

### INDUSTRIAL APPLICABILITY

As apparent from the above description, the solar cell according to the present invention can achieve a significant improvement of a photoelectric conversion efficiency by minimizing a reflectivity of absorbed light via provision of a dual reflective film structure composed of a passivation layer and an anti-reflective layer, in conjunction with effective prevention of carrier recombination occurring at a semiconductor surface by the passivation layer. Further, the present invention enables a significant reduction of production costs by mass production capability via in situ continuous formation of the dual reflective film structure.

## Claims

1. A solar cell comprising a first conductivity type semiconductor substrate (11), a second conductivity type semiconductor layer (12) formed on the first conductivity type semiconductor substrate (11) and having a conductivity type opposite to that of the substrate (11), a p-n junction (13) at an interface therebetween, a rear electrode (21) in contact with at least a portion of the first conductivity type semiconductor substrate (11), a front electrode (22) in contact with at least a portion of the second conductivity type semiconductor layer (12), and a silicon oxynitride passivation layer (14) and a silicon nitride anti-reflective layer (15) sequentially formed on a rear surface of the first conductivity type semiconductor substrate (11) and on a front surface of the second conductivity type semiconductor layer (12), **characterised in that** the passivation layer (14) has a thickness of 30 to 40 nm.

2. The solar cell according to claim 1, wherein the passivation layer (14) has a thickness of 30 or 40 nm.

3. The solar cell according to claim 1 or claim 2, wherein the anti-reflective layer (15) has a refractive index of 1.9 to 2.3.

4. The solar cell according to claim 1 or claim 2, wherein the first conductivity type semiconductor substrate (11) is a p-type silicon substrate and the second conductivity type semiconductor layer (12) is an n-type emitter layer.

## Patentansprüche

1. Solarzelle, die Folgendes umfasst: ein Halbleitersubstrat eines ersten Leitfähigkeitstyps (11), eine Halbleiterschicht eines zweiten Leitfähigkeitstyps (12), die auf dem Halbleitersubstrat des ersten Leitfähigkeitstyps (11) ausgebildet ist und einen Leitfähigkeitstyp hat, der dem des Substrats (11) entgegengesetzt ist, einen p-n-Übergang (13) an einer Grenzfläche zwischen beiden, eine rückseitige Elektrode (21) in Kontakt mit mindestens einem Abschnitt des Halbleitersubstrats vom ersten Leitfähigkeitstyp (11), eine vorderseitige Elektrode (22) in Kontakt mit mindestens einem Abschnitt der Halbleiterschicht des zweiten Leitfähigkeitstyps (12), und eine Siliziumoxynitrid-Passivierungsschicht (14) und einen Siliziumnitrid-Antireflexionsschicht (15), die nacheinander auf einer Rückseite des Halbleitersubstrats vom ersten Leitfähigkeitstyp (11) und auf einer Vorderseite der Halbleiterschicht vom zweiten Leitfähigkeitstyp (12) ausgebildet sind, **dadurch gekennzeichnet, dass** die Passivierungsschicht (14) eine Dicke von 30 bis 40 nm hat.

2. Solarzelle nach Anspruch 1, wobei die Passivierungsschicht (14) eine Dicke von 30 oder 40 nm hat.

3. Solarzelle nach Anspruch 1 oder Anspruch 2, wobei die Antireflexionsschicht (15) einen Brechungsindex von 1,9 bis 2,3 hat.

4. Solarzelle nach Anspruch 1 oder Anspruch 2, wobei das Halbleitersubstrat vom ersten Leitfähigkeitstyp (11) ein Siliziumsubstrat vom p-Typ ist und die Halbleiterschicht vom zweiten Leitfähigkeitstyp (12) eine Emitterschicht vom n-Typ ist.

## Revendications

1. Cellule solaire comprenant un substrat semi-conducteur de premier type de conductivité (11), une couche semi-conductrice de deuxième type de conductivité (12) formée sur le substrat semi-conducteur de premier type de conductivité (11) et ayant un type de conductivité opposé à celui du substrat (11), une jonction p-n (13) au niveau d'une interface entre ceux-ci, une électrode arrière (21) en contact avec au moins une partie du substrat semi-conducteur de premier type de conductivité (11), une électrode avant (22) en contact avec au moins une partie de la couche semi-conductrice de deuxième type de conductivité (12), et une couche de passivation d'oxynitrure de silicium (14) et une couche anti-réfléchissante de nitrure de silicium (15) formées successivement sur une surface arrière du substrat semi-conducteur de premier type de conductivité (11) et sur une surface avant de la couche semi-conductrice de deuxième type de conductivité (12), la couche de passivation (14) a une épaisseur allant de 30 à 40 nm.

2. Cellule solaire selon la revendication 1, dans laquelle la couche de passivation (14) a une épaisseur de 30 ou 40 nm.

3. Cellule solaire selon la revendication 1 ou 2, dans laquelle la couche anti-réfléchissante (15) a un indice de réfraction allant de 1,9 à 2,3.

4. Cellule solaire selon la revendication 1 ou 2, dans laquelle le substrat semi-conducteur de premier type de conductivité (11) est un substrat de silicium de type p et la couche semi-conductrice de deuxième type de conductivité (12) est une couche d'émetteur de type n.
